# FASCICULE DE BREVET EUROPEEN

(11) **EP 2 050 713 B1**
(45) Date de publication et mention de la délivrance du brevet: **23.05.2012**
(21) Numéro de dépôt: 08354068.2
(22) Date de dépôt: 07.10.2008
(51) Int. Cl.: B81C 1/00, H01L 23/10

(54) **Procédé de réalisation d'une cavité ayant un cordon de scellement**
Verfahren zur Herstellung eines Hohlraums mit einem Dichtwulst
Method of manufacturing a cavity having a seal bead

(30) Priorité: 15.10.2007 FR 0707213
(43) Date de publication de la demande: 22.04.2009
(73) Titulaire: Commissariat à l'Énergie Atomique et aux Énergies Alternatives, 75015 Paris (FR)
(72) Inventeur: Baillin, Xavier, F-38920 Crolles (FR); Brun, Jean, F-38800 Champagnier (FR); Enot, Thierry, F-38190 Villard-Bonnot (FR); Henry, David, F-38240 Meylan (FR)
(74) Mandataire: Hecké, Gérard

(56) Documents cités:
- EP-A- 0 794 558
- WO-A-2005/118463
- US-A1- 2001 012 088
- US-B1- 6 428 650
- US-B1- 6 589 625
- US-B1- 6 791 660

## Description

### Domaine technique de l'invention

L'invention est relative à un procédé de réalisation d'une structure comportant deux substrats en regard collés l'un à l'autre par écrasement d'un cordon de scellement périphérique fermé, le cordon de scellement délimitant, entre les substrats, une cavité fermée.

L'invention concerne également la structure obtenue par ce procédé.

### État de la technique

Les dispositifs tels que les micro-systèmes et par exemple les systèmes de type micro-élecro-mécaniques (MEMS) ou micro-opto-électro-mécaniques (MOEMS), réalisés suivant les technologies de la microélectronique sont des objets qui nécessitent, compte tenu de leur taille et de leur fragilité, d'être protégés des agressions extérieures. C'est pourquoi, l'encapsulation des micro-systèmes, notamment lorsqu'ils sont encore solidaires de leur substrat initial, représente une solution attractive pour une manipulation aisée et une réduction des coûts.

Le collage d'un capot sur un substrat avec un cordon de résine est classique dans la littérature et décrit notamment dans l'article de Oberhammer et al. « Selective wafer-level adhesive bonding with benzocyclobutene for fabrication of cavities », Sensors and Actuators A 105 (2003), 297-304.

Le brevet américain US6428650 B1 décrit le également le collage d'un capot sur un substrat avec un cordon de résine. Ce cordon de scellement est discontinu, les zones vides du cordon contribuant à équilibrer la pression à l'intérieur de la cavité lors de sa fermeture par écrasement.

Alors que dans le domaine de la microélectronique, les motifs et les règles de dessin qui leur sont associées font l'objet d'études approfondies, les dessins des cordons de scellement ne prennent pas en compte l'optimisation de la surface de la puce ou la tenue mécanique du cordon de scellement. De plus, la déformation du joint de scellement n'est pas prise en compte dans le contrôle de la hauteur de la cavité délimitée par le joint ni dans l'optimisation de la surface active de la puce. L'emploi d'un cordon présente l'inconvénient majeur de la maîtrise de ses cotes finales après écrasement. En particulier, il peut être amené à déborder sur les zones actives du dispositif et affecter le bon fonctionnement de celui-ci après scellement des deux substrats.

### Objet de l'invention

L'invention a pour but d'écarter les inconvénients des procédés connus et plus particulièrement de permettre la réalisation, par un procédé facile à mettre en oeuvre, d'une structure dont la déformation du cordon de scellement soit mieux contrôlée, pour assurer ainsi un meilleur contrôle des dimensions de la cavité ainsi qu'une meilleur adhérence entre les deux substrats.

Selon l'invention, ce but est atteint par le fait que le cordon de scellement comporte, avant écrasement, des motifs ajourés constitués par des barres trouées par des zones vides perpendiculairement aux substrats à l'intérieur du cordon.

L'invention a également pour objet une structure obtenue par ce procédé.

### Description sommaire des dessins

D'autres avantages et caractéristiques ressortiront plus clairement de la description qui va suivre de modes particuliers de réalisation de l'invention, donnés à titre d'exemples non limitatifs et représentés aux dessins annexés, dans lesquels :
- la figure 1 représente une vue schématique en coupe d'une structure selon l'art antérieur,
- la figure 2 représente, schématiquement, une vue de dessus d'une structure selon l'invention,
- les figures 3 et 4 représentent, schématiquement, en vue de dessus, une portion de plusieurs modes de réalisation d'un cordon utilisé dans le procédé selon l'invention,
- les figures 5 et 6 représentent, schématiquement, en vue de dessus, un exemple de zones de renforts, selon l'invention,
- la figure 7 représente, schématiquement, en vue de dessus, une structure comportant deux cavités fermées selon l'invention.

### Description d'un mode de réalisation préférentiel de l'invention

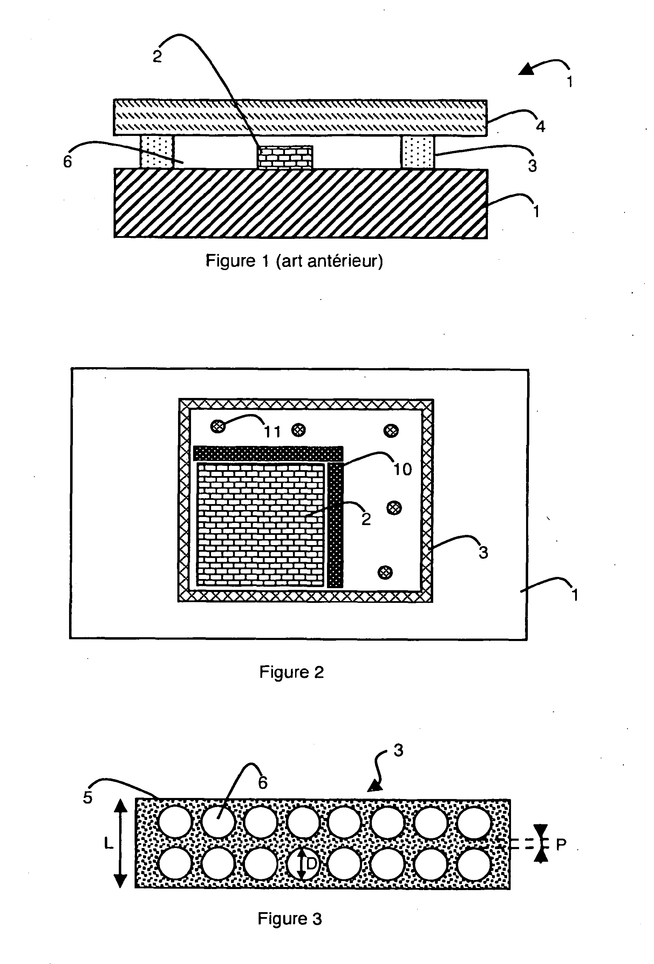

Comme illustré sur les figures 1 et 2, un premier substrat 1 comporte un dispositif, par exemple un microsystème 2, tel qu'un système micro-électro-mécanique (« Micro Electro Mechanical System en anglais ») ou un système micro-opto-électro-mécanique (« Micro Opto Electro Mechanical System »). Le microsystème 2, réalisé de manière classique, est solidaire du premier substrat 1. Il peut être directement intégré sur le premier substrat 1 qui est alors avantageusement en silicium, ou rendu solidaire de celui-ci après sa formation. Le premier substrat 1 peut également être en verre.

Un cordon de scellement 3 périphérique fermé est alors formé, de manière classique, sur le premier substrat 1 autour du microsystème 2. Le cordon de scellement 3 est déposé par toute technique adaptée, par exemple par dépôt à la tournette puis est structuré par photolithographie et gravure au moyen d'une résine photosensible supplémentaire ou directement par insolation et développement si le cordon de scellement 3 est réalisé dans un matériau photosensible et adhérant. Le cordon de scellement 3 peut également être structuré par sérigraphie, dispense ou estampage. La hauteur du cordon 3 est, avantageusement, comprise entre 2 et 10 µm et sa largeur est avantageusement comprise entre 100 et 300 µm.

Comme illustré à la figure 1, de manière classique, un second substrat 4, assimilable à un substrat supérieur ou à un capot, est posé sur le cordon de scellement 3 en regard du substrat 1 et du dispositif 2. Le cordon de scellement 3 est alors écrasé et les deux substrats sont collés l'un à l'autre. Le collage est réalisé, de préférence, en maintenant une contrainte qui assure une certaine tenue mécanique. Le collage peut être également effectué dans une enceinte permettant de contrôler la nature de l'atmosphère ambiante et la pression dans la cavité fermée, délimitée par les deux substrats 1, 4 et le cordon de scellement 3 dans laquelle est disposé le microsystème 2. Les deux substrats, sensiblement parallèles, sont alors collés au moyen du joint de scellement 3. La cavité obtenue est avantageusement étanche voire hermétique et protège le microsystème 2 des agressions extérieures.

Le substrat supérieur 4 peut être en silicium ou avantageusement en verre et être structuré afin de moduler la hauteur de la cavité par rapport au cordon de scellement 3. Le collage peut être réalisé thermiquement et/ou par insolation, par exemple, par UltraViolet suivant la nature des matériaux utilisés.

Afin de contrôler la déformation du cordon de scellement 3 lors de son écrasement, au moins avant écrasement, le cordon de scellement 3 présente des motifs d'ajourés 5 délimitant une pluralité de zones vides 6. Les motifs ajourés 5 du cordon de scellement 3 sont assimilés à des barres trouées par des zones vides 6, avantageusement perpendiculaires au substrat, par exemple avec un axe de symétrie perpendiculaire au substrat. Dans le mode de réalisation particulier de la figure 3, des zones de déformation privilégiée sont formées par des orifices 6 traversant le cordon sur toute sa hauteur et avantageusement répartis à intervalle régulier le long du cordon. Cependant, la répartition des orifices 6 peut être modifiée suivant les applications, notamment lorsque la structure comporte des zones d'accès dans au moins un des substrats 1 et 4 et à proximité immédiate du cordon. Ainsi, avantageusement, à proximité des zones d'accès, le cordon de scellement 3 ne comporte pas d'orifices 6 ou comporte alors des orifices de tailles plus faibles. Cette précaution permet notamment d'éviter la fragilisation de ces zones.

Si le dispositif 2 est de type microélectronique, la structure peut être une puce microélectronique. Cependant, la structure peut comporter tout autre type de dispositif qui doit être protégé de l'extérieur par une cavité.

Dans le mode de réalisation particulier illustré à la figure 3, le cordon comporte deux rangées parallèles d'orifices cylindriques 6.

Le cordon 3 de scellement n'est donc plus comme dans l'art antérieur un fil continu, homogène et fermé qui entoure le microsystème 2, mais un cordon fermé sur lui-même et présentant des zones vides. Les motifs ajourés 5 sont contigus et peuvent présenter une ou plusieurs séries de trous, de préférence cylindriques, alignés ou en quinconce. Un cordon fermé sur lui-même est un cordon continu ou discontinu qui forme une boucle fermée, les discontinuités du cordon n'étant pas prises en compte car elles disparaissent après écrasement.

Les motifs 5 délimitant une pluralité de zones vides améliorent la propension du cordon 3 à l'écrasement comparé à un cordon plein. Ainsi, la surface de contact et donc l'adhérence entre le cordon 3 et les deux substrats 1 et 4 est améliorée. Les motifs 5 permettent également de moduler et contrôler la déformation du cordon 3 lors de l'écrasement et ainsi de maîtriser sa structure tridimensionnelle finale. Cette approche est particulièrement intéressante lorsqu'un cordon doit être placé à proximité immédiate d'un microsystème et qu'une déformation excessive du cordon peut altérer le bon fonctionnement du microsystème 2. Cette approche est particulièrement avantageuse lorsque le dispositif présente des parties mobiles, ou tout autre zone dont la fonction est altérée par la présence d'une résine à son contact. Ce mode de réalisation est également intéressant lorsque le dispositif possède une fonction optique et que le matériau constituant le cordon 3 n'est pas transparent au rayonnement lumineux qui est associé au dispositif optique.

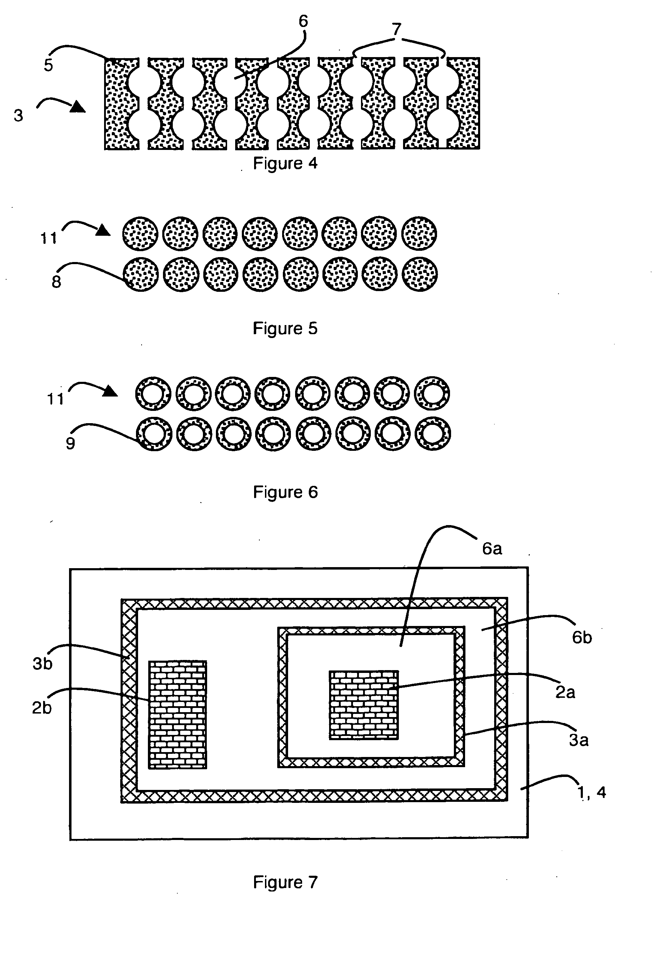

Comme illustré à la figure 4, les motifs ajourés 5 peuvent former des zones vides traversantes 7 parallèlement au substrat et perpendiculairement au cordon 3. Les zones vides traversantes 7 relient les deux faces latérales du cordon avant écrasement. Des zones vides 6 sont ajoutées aux zones 7 qui traversent le cordon. Les zones vides sont, par exemple, constituées par des trous cylindriques 6 perpendiculaires au substrat. Les zones vides traversantes (6, 7) qui empêchent, avant écrasement, l'étanchéité de la cavité, se referment lors de la déformation du cordon par écrasement pour assurer l'étanchéité de la cavité. Ces zones vides traversantes permettent ainsi un meilleur contrôle de la pression au sein de la cavité juste avant que celle-ci ne devienne étanche. De cette manière, il est plus facile de contrôler la position du substrat supérieur 4, particulièrement lorsque l'on cherche un écart très faible entre le microsystème 2 et le substrat supérieur 4. En pratique, les évents latéraux 7 sont formés en même temps que les orifices, par exemple par photolithographie. Ils sont alors également formés sur toute la hauteur du cordon, qui peut donc être discontinu. Un cordon de scellement 3 discontinu permet, avant son écrasement, une mise en contact aisée de l'atmosphère de la cavité avec son environnement extérieur. Un cordon de scellement 3 discontinu peut permettre le dégazage des parois internes de la cavité avant que les évents 7 ne soient fermés. Un dessin de cordon tel que celui décrit sur la figure 4 et qui allie des évents 7 à des zones vides 6, permet à la fois de contrôler les dimensions finales du cordon 3, mais aussi, en partie, l'atmosphère résiduelle dans la cavité après scellement.

Avantageusement, dans un plan parallèle aux substrats, le dessin du cordon de scellement 3 répond à au moins un des critères suivants :
- La surface occupée par le cordon 3 ajouré, c'est-à-dire la surface occupée, avant écrasement, par la résine est égale ou supérieure à environ 5% de la surface du substrat inférieur 1 supportant le microsystème 2. Avantageusement, ce rapport est compris entre 10% et 20%.
- Le rapport entre la surface des zones vides et la surface totale du cordon plein (sans les zone vides) est compris entre 10% et 50%.
- Le rapport entre l'espacement bord à bord (D, figure 3) entre deux zones vides adjacentes et la plus petite dimension latérale de la zone vide est inférieur à 1, de préférence, compris entre 0,5 et 0,8.
- La largeur des évents 7 est inférieure à la dimension des zones vides 6 (leur diamètre quand elles sont de forme cylindriques) et de préférence comprise entre 20% et 50% de celle-ci.

Avantageusement, des motifs ajourés 5 délimitent des zones vides, de préférence, cylindriques et perpendiculaires aux substrats.

Dans le mode de réalisation de la figure 3, D étant le diamètre de chaque orifice 6. La relation entre le nombre K de zones vides (orifices 6), le diamètre D de ces zones et la largeur L du cordon 3 est donnée par : **L = K.D + (K+1).P**, P étant la distance entre 2 orifices adjacents.

Un cordon additionnel 10 peut également être réalisé à l'intérieur de la surface délimitée par le cordon de scellement 3 (figure 2). Le cordon additionnel 10 permet d'augmenter la surface de contact entre les substrats 1, 4 et donc l'adhésion entre les deux substrats. De cette manière, la tenue mécanique de l'ensemble de la puce s'en trouve augmentée. En effet, si après amincissement de l'un des substrats 1, 4, ce dernier se transforme en une membrane flexible, il est avantageux de placer un cordon additionnel 10 au plus près du microsystème pour augmenter la tenue mécanique autour du microsystème 2. Le cordon additionnel 10 peut présenter ou non des motifs ajourés 5. Le cordon additionnel 10 peut être formé en même temps que le cordon de scellement 3 au cours de la même étape technologique.

Le cordon additionnel 10 peut entourer totalement ou partiellement le microsystème 2 et n'être formé, comme sur la figure 2, que sur un, deux ou trois côtés de celui-ci. Dans le cas d'un cordon additionnel 10 non fermé après scellement, la pression résiduelle est donc identique dans tout le volume défini par le cordon 3 et les substrats 1 et 4.

Dans le cas où un cordon additionnel 10 ne peut pas être réalisé facilement, des renforts 11 sont avantageusement placés au sein de la puce, en des endroits prédéterminés entre le microsystème 2 et le cordon de scellement 3 (figure 2). Les renforts 11, qui assurent comme le cordon additionnel 10 une fonction mécanique, ont avantageusement la forme de piliers pleins 8 ou creux 9 (figures 5 et 6). Avantageusement, les piliers pleins et creux (8, 9) et les orifices 6 ont des diamètres du même ordre de grandeur. Typiquement, le diamètre des piliers pleins 8 est sensiblement égal à D alors que celui des piliers creux est légèrement supérieur à D.

Si des cordons additionnels 10 et/ou des renforts 11 sont utilisés, les rapports des résines définis plus haut peuvent être répartis sur plusieurs cordons eUou renfort.

Avantageusement, deux cordons additionnels 10 sont réalisés au sein de la puce au plus près du microsystème 2. Cependant, plus de trois cordons additionnels 10 peuvent être envisagés. Dans le cas où une pluralité de cordons 3, 10 sont utilisés, une hiérarchisation des cordons peut être effectuée. Ainsi, le cordon de scellement 3 contrôle l'écrasement de la résine et donc l'écartement entre les deux substrats 1 et 4 tandis que les cordons additionnels 10 servent uniquement de renfort adhésif et sont donc, de préférence, de largeur inférieure au cordon de scellement 3.

Si une pluralité de puces ayant des tailles différentes sont à encapsuler sur un même substrat de départ, le rapport de surface entre la résine et chaque puce peut être uniformisé. La largeur du cordon de scellement 3 est fixée pour obtenir le rapport désiré sur la plus petite des puces, la même largeur L est conservée, de préférence, pour toutes les puces. Pour conserver un même rapport de surface résine/puce pour les puces présentant des surfaces plus importantes, le manque de résine est, de préférence, compensé selon la géométrie par ajout d'un ou plusieurs cordons additionnels 10 et/ou de renforts 11.

Les cordons de scellement 3 ou additionnels 10 et les renforts 11 peuvent être réalisés lors d'une même étape de photolithographie, avantageusement à partir d'une même résine photosensible. La résine photosensible peut être choisie, par exemple, parmi les résines négatives BCB (benzocyclobutène, correspondant au produit Cyclotene de la série 4000) commercialisées par la société Dow Chemical, SC Resist commercialisées par la société Fujifilm, WPR commercialisées par la société JSR. Pour ce type d'adhésif, le procédé de scellement consiste généralement à maintenir les deux substrats sous contrainte tout en polymérisant la résine en température. Les conditions de la contrainte appliquée sur les substrats, la température et la durée du scellement sont propres à chaque produit utilisé. Ces conditions peuvent être adaptées pour chaque résine en fonction de l'application visée. A titre d'exemple, il est possible de réaliser un cordon de scellement d'une épaisseur finale d'environ 6µm en BCB (Cyclotene 4024-40) par application d'une contrainte de l'ordre du mégapascale (MPa) résolue sur l'ensemble de la surface définie par la résine à 250°C pendant une heure. Le contrôle de l'épaisseur peut ainsi être maîtrisé à quelques dixièmes de micron près. Il n'est donc pas nécessaire d'ajouter des charges minérales, qui auraient pour fonction de servir de cale d'ajustement de l'épaisseur finale.

Les cordons de scellement 3 ou additionnels 10 et les renforts 11 peuvent également être réalisés par les techniques de formage type sérigraphie, dispense ou estampage si le matériau utilisé n'est pas photosensible.

Dans le cas où l'un des deux substrats est transparent au rayonnement optique, par exemple en verre, et si des renforts 11 ou des zones vides 6 d'un motif ajouré 5 sont symétriques et de préférence cylindriques, une première mesure de leur diamètre lors de leur définition et une seconde après le scellement des deux substrats 1, 4 permet de contrôler leur déformation. Par cette méthode, l'homogénéité de l'écrasement du cordon 3 lors du collage et donc la qualité du scellement est contrôlée. Des piliers (8, 9) ou une zone vide 6 d'un motif ajouré 5 d'un cordon (3, 10) peuvent être avantageusement utilisés pour réaliser optiquement depuis l'extérieur, un contrôle aisé de leur structure dimensionnelle et donc de la qualité de l'écrasement du cordon de scellement 3 à des endroits prédéterminés de la puce. Lorsque deux substrats 1, 4 sont en silicium, un contrôle dimensionnel identique peut être réalisé au moyen d'un microscope infra-rouge.

Dans un autre mode de réalisation particulier, illustré à la figure 7, dans lequel le dispositif comporte deux parties référencées 2a et 2b, deux cavités fermées 6a et 6b, peuvent être réalisées, chacune des cavités comportant une des parties du dispositif. La cavité 2a est disposée dans la cavité 2b.

Ces deux cavités peuvent présenter des atmosphères différentes et des pressions contrôlées différentes. Ce cas de figure peut être obtenu si, par exemple, le cordon de scellement 3 comporte un cordon intérieur 3a et un cordon extérieur 3b. Le cordon extérieur 3b entoure la partie 2b du dispositif et comporte des évents, ou des zones vides traversantes 7. Lors du cycle de scellement des deux substrats 1, 4, la mise en contact de ces derniers peut être faite sous un premier gaz G1 à une première pression P1. En contrôlant la contrainte appliquée sur les substrats 1,4, il est possible de fermer la cavité intérieure 6a définie par le cordon intérieur 3a et les deux substrats 1, 4, sous une première atmosphère (G1, P1), alors que le cordon extérieur 3b n'est pas hermétique. Le cordon 3a est partiellement écrasé alors que les évents du cordon extérieur 3b sont encore partiellement ouverts. Il est alors possible de remplir la cavité extérieure 6b, contenant la partie 2b du dispositif et délimité par le cordon intérieur 3a, le cordon extérieur 3b et les deux substrats par une atmosphère contrôlée, un second gaz G2, différent ou non du premier gaz, sous une seconde pression P2. L'augmentation de la contrainte appliquée sur les deux substrats, permet alors de fermer la cavité extérieure 6b. La propension à l'écrasement du cordon intérieur 3a est supérieure à celle du cordon extérieur 3b, ce qui peut facilement être obtenu par ajustement des taux d'ajourement respectifs des deux cordons. Sur le plan de la réalisation technologique, il sera plus intéressant d'utiliser un même gaz, par exemple, de l'azote ou de l'argon. Pour des raisons de clarté, le substrat supérieur 4 est considéré comme transparent sur la figure 7 et est représenté avec le substrat 1.

## Revendications

1. Procédé de réalisation d'une structure comportant deux substrats (1, 4) en regard collés l'un à l'autre par écrasement d'un cordon de scellement (3) périphérique fermé sur lui-même, le cordon de scellement (3) délimitant une cavité fermée entre les substrats (1, 4), procédé **caractérisé en ce que** le cordon de scellement (3) comporte, avant écrasement, une pluralité de motifs ajourés constitués par des barres trouées par des zones vides (6) perpendiculairement aux substrats à l'intérieur du cordon (3).

2. Procédé selon la revendication 1, **caractérisé en ce que**, dans un plan parallèle aux substrats, le rapport entre la surface des zones vides du cordon de scellement (3) et la surface totale du cordon est compris entre 10% et 50%.

3. Procédé selon l'une quelconque des revendications 1 à 2, **caractérisé en ce que** les zones vides (6) sont cylindriques perpendiculairement aux substrats (1, 4).

4. Procédé selon l'une quelconque des revendications 1 à 3, **caractérisé en ce que** les motifs ajoutés forment en outre des zones vides (7) traversantes perpendiculaires à des faces latérales du cordon et parallèlement aux substrats (1, 4).

5. Procédé selon l'une quelconque des revendications 1 à 4, **caractérisé en ce que** le rapport entre l'espacement bord à bord (P) entre deux zones vides adjacentes et la plus petite dimension latérale de la zone vide est inférieur à 1.

6. Procédé selon la revendication 5, **caractérisé en ce que** le rapport entre l'espacement bord à bord (P) entre deux zones vides adjacentes et la plus petite dimension latérale de la zone vide est compris entre 0,5 et 0,8.

7. Procédé selon l'une quelconque des revendications 1 à 6, **caractérisé en ce que** le cordon de scellement (3) est discontinu avant le collage des substrats (1, 4), puis continu après scellement des deux substrats (1, 4).

8. Procédé selon l'une quelconque des revendications 1 à 7, **caractérisé en ce qu'**il comporte un cordon additionnel (10) et/ou des renforts (11).

9. Procédé selon l'une quelconque des revendications 1 à 8, **caractérisé en ce que** l'un des substrats (1, 4) comportant une zone optiquement transparente située au-dessus d'un pilier (8, 9) et/ou d'une zone vide (6) d'un motif ajouré (5), l'homogénéité de l'écrasement est contrôlée par la mesure des dimensions du pilier (11) et/ou de la zone vide (6) du motif ajouré (5) après sa formation et après collage.

10. Procédé selon l'une des revendications 8 et 9, **caractérisé en ce que** le cordon de scellement (3), le cordon additionnel (10) et les renforts (11) sont réalisés dans le même matériau et lors de la même étape technologique.

11. Procédé selon l'une quelconque des revendications 1 à 10, **caractérisé en ce que** le cordon de scellement (3) est en résine photosensible de polarité négative.

12. Procédé selon l'une quelconque des revendications 1 à 11, **caractérisé en ce qu'**un cordon additionnel (10) et/ou un renfort (11) est disposé à l'intérieur de la surface délimitée par le cordon de scellement (3).

13. Procédé selon la revendication 12, **caractérisé en ce que** le cordon additionnel (10) a une largeur inférieure au cordon de scellement (3).

14. Procédé selon l'une quelconque des revendications 1 à 13, **caractérisée en ce qu'**un cordon intérieur (3a) est formé à l'intérieur du cordon de scellement (3b) extérieur, les cordons intérieur et extérieur (3a, 3b) définissant respectivement des première et seconde cavités (6a, 6b) ayant des atmosphères différentes, la première cavité (6a) étant disposée dans la seconde cavité (6b).

## Claims

1. A method for producing a structure comprising two facing substrates (1, 4) bonded to one another by crushing a peripheral sealing strip (3) closed on itself, the sealing strip (3) delineating a closed cavity between the substrates (1, 4), method **characterized in that**, before crushing, the sealing strip (3) comprises a plurality of perforated patterns constituted by bars perforated by voids (6) perpendicularly to the substrates inside the strip (3).

2. The method according to claim 1, **characterized in that**, in a plane parallel to the substrates, the ratio between the surface of the voids of the sealing strip (3) and the total surface of the strip is comprised between 10% and 50%.

3. The method according to one of claims 1 and 2, **characterized in that** the voids (6) are cylindrical perpendicularly to the substrates (1, 4).

4. The method according to any one of claims 1 to 3, **characterized in that** perforated patterns further form passing through voids (7) perpendicular to side faces of the strip and parallel to the substrates (1, 4)

5. The method according to any one of claims 1 to 4, **characterized in that** the ratio between the edge to edge spacing (P) between two adjacent voids and the smallest lateral dimension of the void is less than 1.

6. The method according to claim 5, **characterized in that** the ratio between the edge to edge spacing (P) between two adjacent voids and the smallest lateral dimension of the void is comprised between 0.5 and 0.8.

7. The method according to any one of claims 1 to 6, **characterized in that** the sealing strip (3) is discontinuous before bonding of the substrates (1, 4), and then continuous after sealing of the two substrates (1, 4).

8. The method according to any one of claims 1 to 7, **characterized in that** it comprises an additional strip (10) and/or strengtheners (11).

9. The method according to any one of claims 1 to 8, **characterized in that** one of the substrates (1, 4) comprising an optically transparent area situated above a pillar (8, 9) and/or a void (6) of a perforated pattern (5), homogeneity of crushing is checked by measuring the dimensions of the pillar (11) and/or of the void (6) of the perforated pattern (5) after formation of the latter and after bonding.

10. The method according to one of claims 8 and 9, **characterized in that** the sealing strip (3), additional strip (10) and strengtheners (11) are made from the same material and in the same technological step.

11. The method according to any one of claims 1 to 10, **characterized in that** the sealing strip (3) is made of negative polarity photoresist.

12. The method according to any one of claims 1 to 11, **characterized in that** it comprises at least one additional strip (10) and/or a strengthener (11) inside the surface delineated by the sealing strip (3).

13. The method according to 12, **characterized in that** the additional strip (10) has a smaller width than the sealing strip (3).

14. The structure according to any one of claims 1 to 13, **characterized in that** an internal strip( 3a) is formed inside the external sealing strip (3b), the internal and external strips (3a, 3b) respectively define first and second cavities (6a, 6b) having different atmospheres, the first cavity (6a) being arranged in the second cavity (6b).

## Patentansprüche

1. Verfahren zur Herstellung einer Struktur, die zwei gegenüberliegende Substrate (1, 4) umfasst, welche durch Zusammendrücken eines in sich geschlossenen, umlaufenden Dichtungswulstes (3) aneinander geklebt sind, wobei der Dichtungswulst (3) einen geschlossenen Hohlraum zwischen den Substraten (1,4) begrenzt, Verfahren, das **dadurch** gekenntzeichnet ist, dass der Dichtungswulst (3) vor dem Zusammendrücken eine Vielzahl von durchbrochenen Mustern aufweist, die von Balken, welche durch Leerbereiche (6) senkrecht zu den Substraten innerhalb des Wulstes (3) durchlöchert sind, gebildet sind.

2. Verfahren nach Anspruch 1, **dadurch gekennzeichnet, dass** in einer Ebene parallel zu den Substraten das Verhältnis zwischen der Fläche der Leerbereiche des Dichtungswulstes (3) und der Gesamtfläche des Wulstes zwischen 10 % und 50 % liegt.

3. Verfahren nach einem der Ansprüche 1 bis 2, **dadurch gekennzeichnet, dass** die Leerbereiche (6) senkrecht zu den Substraten (1, 4) zylindrisch sind.

4. Verfahren nach einem der Ansprüche 1 bis 3, **dadurch gekennzeichnet, dass** die durchbrochenen Muster ferner durchgehende Leerbereiche (7) senkrecht zu Seitenflächen des Wulstes und parallel zu den Substraten (1, 4) bilden.

5. Verfahren nach einem der Ansprüche 1 bis 4, **dadurch gekennzeichnet, dass** das Verhältnis zwischen dem Seite-an-Seite-Zwischenraum (P) zwischen zwei benachbarten Leerbereichen und der kleinsten Seitenabmessung des Leerbereichs kleiner als 1 ist.

6. Verfahren nach Anspruch 5, **dadurch gekennzeichnet, dass** das Verhältnis zwischen dem Seite-an-Seite-Zwischenraum (P) zwischen zwei benachbarten Leerbereichen und der kleinsten Seitenabmessung des Leerbereichs zwischen 0,5 und 0,8 liegt.

7. Verfahren nach einem der Ansprüche 1 bis 6, **dadurch gekennzeichnet, dass** der Dichtungswulst (3) vor dem Verkleben der Substrate (1, 4) unterbrochen ist, anschließend nach dem Verschließen der beiden Substrate (1, 4) durchgehend ist.

8. Verfahren nach einem der Ansprüche 1 bis 7, **dadurch gekennzeichnet, dass** es einen zusätzlichen Wulst (10) und/oder Verstärkungen (11) umfasst.

9. Verfahren nach einem der Ansprüche 1 bis 8, **dadurch gekennzeichnet, dass** das eine der Substrate (1, 4) einen optisch transparenten Bereich umfasst, der oberhalb eines Pföstchens (8, 9) und/oder eines Leerbereichs (6) eines durchbrochenen Musters (5) gelegen ist, wobei die Homogenität des Zusammendrückens durch das Maß der Abmessungen des Pföstchens (11) und/oder des Leerbereichs (6) des durchbrochenen Musters (5) nach seiner Bildung und nach dem Verkleben kontrolliert wird.

10. Verfahren nach einem der Ansprüche 8 und 9, **dadurch gekennzeichnet, dass** der Dichtungswulst (3), der zusätzliche Wulst (10) sowie die Verstärkungen (11) aus dem gleichen Werkstoff und während des gleichen technologischen Schrittes hergestellt werden.

11. Verfahren nach einem der Ansprüche 1 bis 10, **dadurch gekennzeichnet, dass** der Dichtungswulst (3) aus lichtempfindlichem Harz mit negativer Polarität besteht.

12. Verfahren nach einem der Ansprüche 1 bis 11, **dadurch gekennzeichnet, dass** ein zusätzlicher Wulst (10) und/oder eine Verstärkung (11) innerhalb der durch den Dichtungswulst (3) begrenzten Fläche angeordnet ist.

13. Verfahren nach Anspruch 12, **dadurch gekennzeichnet, dass** der zusätzliche Wulst (10) eine geringere Breite als der Dichtungswulst (3) aufweist.

14. Verfahren nach einem der Ansprüche 1 bis 13, **dadurch gekennzeichnet, dass** ein Innenwulst (3a) innerhalb des äußeren Dichtungswulstes (3b) ausgebildet wird, wobei der innere und der äußere Wulst (3a, 3b) einen ersten bzw. einen zweiten Hohlraum (6a, 6b) mit unterschiedlichen Atmosphären definieren, wobei der erste Hohlraum (6a) in dem zweiten Hohlraum (6b) angeordnet ist.
